(19) **Europäisches Patentamt**
**European Patent Office**
**Office européen des brevets**

(11) **EP 4 586 429 A1**

(12) **EUROPEAN PATENT APPLICATION**

(43) Date of publication:
**16.07.2025 Bulletin 2025/29**

(21) Application number: **24206941.7**

(22) Date of filing: **16.10.2024**

(51) International Patent Classification (IPC):
**H02H 3/40** (2006.01)    **H02H 3/38** (2006.01)
**G01R 31/08** (2020.01)    **G01R 31/52** (2020.01)
**H02H 3/04** (2006.01)

(52) Cooperative Patent Classification (CPC):
**H02H 3/405; H02H 3/387; G01R 31/085;**
**H02H 3/042**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **10.01.2024  CN 202410041422**

(71) Applicant: **ABB SCHWEIZ AG**
**5400 Baden (CH)**

(72) Inventors:
• **Liu, Kai**
  **Beijing, 100025 (CN)**
• **Yanjing, Li**
  **Xiamen, Fujian, 361000 (CN)**

(74) Representative: **Zimmermann & Partner**
**Patentanwälte mbB**
**Postfach 330 920**
**80069 München (DE)**

(54) **METHOD FOR IDENTIFYING SYSTEM FAULT DIRECTION, DIRECTIONAL ELEMENT AND RELAY PROTECTION DEVICE**

(57)    The present invention relates to a method for identifying a fault direction in an electric power system, the sequence impedance directional element, and a relay protection device including the element. The electric power system comprises two power supply networks (Vs, Vr) and an electric power transmission line, with a relay protection device (REL1) being arranged at the first endpoint of the electric power transmission line. The method comprises the steps of: measuring the three-phase current flowing through the relay protection device and the three-phase voltage (S101); determining the sequence voltage and sequence current at the relay protection device based on the measured three-phase current and voltage (S102); calculating the sequence impedance at a predetermined compensation point in the electric power transmission line based on the determined sequence voltage and sequence current at the relay protection device (S103); and comparing the calculated sequence impedance at the predetermined compensation point with a reference threshold (S104), and determining the direction of a fault occurring in the electric power system relative to the relay protection device based on the comparison result (S105). The method and the directional element of the present invention can accurately determine the fault direction even under the condition that the negative-sequence voltage at the relay protection device is very small, and they possess a good anti-interference capability.

Fig. 8

FIG. 8

## Description

## Technical Field

The present invention relates to the field of fault detection in electric power systems, and more particularly, to a method for identifying a fault direction in an electric power system, a sequence impedance directional element based on compensation voltage, and a relay protection device including the sequence impedance directional element.

## Background

In an electric power system, directional elements, as key components for ensuring stable operation of the system, play a crucial role in various relay protection devices (e.g., distance protection devices, overcurrent directional protection devices, pilot protection devices based on directional comparison, etc.). These protection devices rely on directional elements to identify the locational relationship of a fault within the system relative to the relay protection device, so as to isolate the fault area in a timely manner.

A phase angle based negative-sequence directional element is a widely used typed of directional element, which generally determines the fault direction based on the phase angle between the negative-sequence voltage and the negative-sequence current. Under normal conditions, this negative-sequence directional elements can work effectively: if the negative-sequence current is identified to lead the negative-sequence voltage, the line fault may be identified as forward; otherwise, it can be identified as reverse line fault.

However, such a negative-sequence directional element cannot function normally when the negative-sequence voltage is very small. For example, in a super-strong system or when a high impedance fault occurs, the negative-sequence voltage at the relay protection device becomes very small, or even close to zero. In such cases, not only the detection of the negative-sequence voltage becomes difficult, but also such a negative-sequence directional element may cause incorrect identification due to noise interference in signals, causing the protection device to fail to correctly identify the direction of the line fault, thereby affecting the safety and reliability of the entire power system.

## Content of the Invention

In order to overcome the defects existing in traditional directional elements, the present invention proposes a negative-sequence impedance directional element based on compensation voltage. The directional element can accurately determine the fault direction even when the negative-sequence voltage at the relay protection device is very small, that is, it maintains high sensitivity to weak negative-sequence voltage signals. Moreover, the directional element also has the capability to resist noise interference, ensuring reliable fault direction determination under various complex operating conditions.

According to a first aspect of the present invention, a method for identifying the fault direction in an electric power system is proposed. The electric power system comprises two power supply networks and an electric power transmission line for transmitting three-phase alternating current between the two power supply networks, with a relay protection device being arranged at a first endpoint of the electric power transmission line. The method aims to determine the direction of a fault occurring in the electric power system relative to the relay protection device, the method comprising the steps of:

measuring the three-phase current flowing through the relay protection device and the three-phase voltage at the relay protection device;
determining the sequence voltage and sequence current at the relay protection device based on the measured three-phase current and three-phase voltage by using a symmetrical component method;
calculating the sequence impedance at a predetermined compensation point in the electric power transmission line based on the determined sequence voltage and sequence current at the relay protection device, wherein the predetermined compensation point is located between the two endpoints of the electric power transmission line and the compensation impedance between the predetermined compensation point and the first endpoint is $Z_{q2}$ , wherein the calculation result of the sequence impedance is associated with the compensation impedance $Z_{q2}$ ; and comparing the calculated sequence impedance at the predetermined compensation point with a reference threshold, and determining the direction of a fault occurring in the electric power system relative to the relay protection device based on the comparison result.

According to the identification method as defined in the first aspect of the present invention, since the compensation point is located within the transmission line, which means that the compensation voltage at the compensation point will not be zero in the event that a fault occurs on the line, the directional element has strong anti-noise capability. In addition, the reference threshold used in this fault identification method is only related to the line impedance and will not change with different systems. Customers do not need to set any threshold parameters for this, further facilitates the use of the product by customers.

According to an optional embodiment, the method further comprises:

determining the fault direction in the electric power system based on the angle information and/or amplitude information of the sequence impedance at the predetermined compensation point.

In this embodiment, it is provided that the directional element can identify the fault direction based on both the angle information and amplitude information of the negative-sequence impedance $Z_{c2}$ at the compensation point. Existing technologies can only use one of the amplitude and angle information to determine the fault direction. For example, some directional elements cannot use the sign of the negative-sequence impedance to determine the fault direction because when the negative-sequence voltage at the relay protection device is close to zero, the negative-sequence impedance is also close to zero. Due to the presence of noise, the determination based on the sign (angle) of the negative-sequence impedance becomes unreliable. however, in the method of the present invention, when a line fault occurs, the negative-sequence compensation voltage will never be zero, therefore both the sign information and the amplitude information of the angle of $Z_{c2}$ can be used to determine the fault direction.

According to an optional embodiment, the sequence voltage comprises the negative-sequence voltage $\dot{U}_2$ at the first endpoint, the sequence current comprises the negative-sequence current $\dot{I}_2$ at the first endpoint, and the sequence impedance comprises the negative-sequence impedance $Z_{c2}$ at the predetermined compensation point.

Although this document focuses on the performance of the directional element according to the present invention under various fault conditions using "negative-sequence impedance" as an example, it is understood that a similar reasoning process can also be extended to zero-sequence or positive-sequence impedances. For example, a zero-sequence (or positive-sequence) impedance directional element based on the compensation voltage can be designed to identify the direction of faults in the system. Such a directional element can also work under conditions where the zero-sequence voltage is very small. It is not only structurally simple but also highly reliable.

According to an optional embodiment, the current in the electric power system flows from the first endpoint to the second endpoint of the electric power transmission line, and the reference threshold comprises a forward reference threshold and a reverse reference threshold larger than the forward reference threshold, wherein the method further comprises:

determining that a reverse fault has occurred in the electric power system when the negative-sequence impedance at the predetermined compensation point is larger than the reverse reference threshold; and
determining that a forward fault has occurred in the electric power system when the negative-sequence impedance at the predetermined compensation point is less than the forward reference threshold.

According to an optional embodiment, the line negative-sequence impedance of the electric power transmission line is $Z_{L2}$, wherein the reference threshold is set based on the line negative-sequence impedance $Z_{L2}$ and the location of the predetermined compensation point in the electric power transmission line.

According to an optional embodiment, assuming the predetermined compensation point is provided at the midpoint of the electric power transmission line, the forward reference threshold is set to $k_1 \times (-Z_{L2}/2)$ and the reverse reference threshold is set to $k_2 \times Z_{L2}/2$, where $k_1, k_2$ are reliability coefficients.

According to an optional embodiment, the sequence impedance angle ? at the predetermined compensation point is determined based on the sequence voltage and sequence current at the first endpoint, and the fault direction in the electric power system is determined based on the sequence impedance angle ? .

According to an optional embodiment, the method further comprises:

determining that a reverse fault has occurred in the electric power system when the negative-sequence impedance angle ? at the predetermined compensation point is within a first reference range; and
determining that a forward fault has occurred in the electric power system when the negative-sequence impedance angle ? at the predetermined compensation point is within a second reference range.

According to an optional embodiment, the first reference range is **-90?~90?** and the second reference range is **90?~270?**.

The above embodiments specify that the fault direction can be directly determined using the sign of the negative-sequence impedance. This is because the negative-sequence impedance angles at the compensation point are completely separated for forward fault and reverse fault, for example, they are always located in the first and second quadrants for forward fault and in the third and fourth quadrants for reverse fault. Therefore, the fault identification method of the present invention has a large degree of distinction for forward fault and reverse fault.

According to a second aspect of the present invention, a sequence impedance directional element based on compensation voltage is also provided. The sequence impedance directional element is arranged in an electric power system comprising two power supply networks and an electric power transmission line for transmitting three-phase alternating current between the two power supply networks. According to an optional embodiment, the directional element is configured to identify a fault direction in the electric power system using the method as described above.

According to a third aspect of the present invention, it is also provided a relay protection device for use in an electric power system. The relay protection device comprises:

the sequence impedance directional element as described above;
a control unit connected to the sequence impedance directional element and configured to output a corresponding control signal to a relay when the sequence impedance directional element identifies a forward fault or a reverse fault; and
a relay connected to the control unit, the relay being configured to disconnect the electric power transmission line upon receiving a control signal from the control unit.

Compared with traditional solutions, the negative-sequence impedance directional element based on compensation voltage and the fault direction identification method according to the present invention have the following advantages:

- First, the directional element can identify the fault direction based on both the angle information and amplitude information of the negative-sequence impedance $Z_{c2}$ at the compensation point. Existing technologies can only use one of the amplitude information and the angle information to determine the fault direction. For example, some directional elements cannot use the sign of the negative-sequence impedance to determine the fault direction because when the negative-sequence voltage at the relay protection device is close to zero, the negative-sequence impedance is also close to zero. Due to the presence of noise, the determination based on the sign (angle) of the negative-sequence impedance becomes unreliable. However, in the method proposed by the present invention, when a line fault occurs, the negative-sequence compensation voltage will never be zero, therefore both the sign information and amplitude information of the angle of $Z_{c2}$ can be used to determine the fault direction;
- The directional element based on $Z_{c2}$ amplitude does not require any settings. The reference threshold of the directional element of the present invention is only related to the line impedance, it will not change with different systems, and customers do not need to set any threshold parameters for this directional element;
- The directional element of the present invention has a greater degree of distinction for forward faults and reverse faults in terms of the negative-sequence impedance exhibited. For the directional element of the present invention, the negative-sequence reference threshold at the compensation point is always negative under forward faults and always positive under reverse faults. In contrast, for existing directional elements, the negative-sequence reference threshold is always positive under reverse faults, but under forward fault, the threshold could be either positive or negative. Therefore, the directional element of the present invention has a greater degree of distinction for forward faults and reverse faults;

- Compared with conventional directional elements, the directional element of the present invention has a larger safety margin between the forward fault area and the reverse fault area;
- The directional element of the present invention can directly determine the fault direction using the sign of the negative-sequence impedance, which has a high reliability and thus a high response speed;
- Since the compensation point is located within the transmission line, it means that the compensation voltage at the compensation point will not be zero in the event of a fault on the line, thus this directional element has strong anti-noise capability;
- The ranges of the negative-sequence impedance at the compensation point are completely separated from each other for forward faults and reverse faults. For example, for forward faults, it is always located in the first and second quadrants, while for reverse faults, it is always located in the third and fourth quadrants.

## Description of the Drawings

Other features and advantages of the method of the present invention will be apparent from, or set forth in more detail in, the accompanying drawings, which are incorporated herein, and the detailed description of the embodiments, which serve to explain certain principles of the present invention together with the drawings.

Fig.1 shows a simplified model diagram of a conventional dual power supply system.
FIG.2 shows a schematic diagram of an electric power system model using a negative-sequence impedance directional element based on compensation voltage.
Fig.3 shows the performance of the directional element based on compensation voltage when a forward fault occurs.

Fig.4 shows the performance of the directional element based on compensation voltage when a reverse fault occurs.

Fig.5 shows the performance of the negative-sequence impedance directional element based on compensation voltage.

Fig.6 shows a model schematic of a fault occurring at different locations of a dual power supply system.

Fig.7A-7D show simulation results of negative-sequence impedance performance at the compensation point when the fault occurs at fault points K1, K2, K3, and K5, respectively.

Fig.8 shows a flowchart of the method for identifying fault direction in an electrical power system according to an exemplary embodiment of the present invention.

## Detailed Description of the Embodiments

The method for identifying a fault direction in an electric power system based on compensation voltage and a negative-sequence impedance directional element according to the present invention will be described below by means of different embodiments and with reference to the drawings. In the following description, numerous specific details are provided to enable those skilled in the art to fully understand the present invention. However, it is apparent to those skilled in the art that the implementation of the present invention may not include some of these specific details. Instead, any combination of the following features and elements may be used to implement the present invention, regardless of whether they involve different embodiments. Therefore, the following aspects, features, embodiments, and advantages are for illustration only and should not be considered as elements or limitations of the claims.

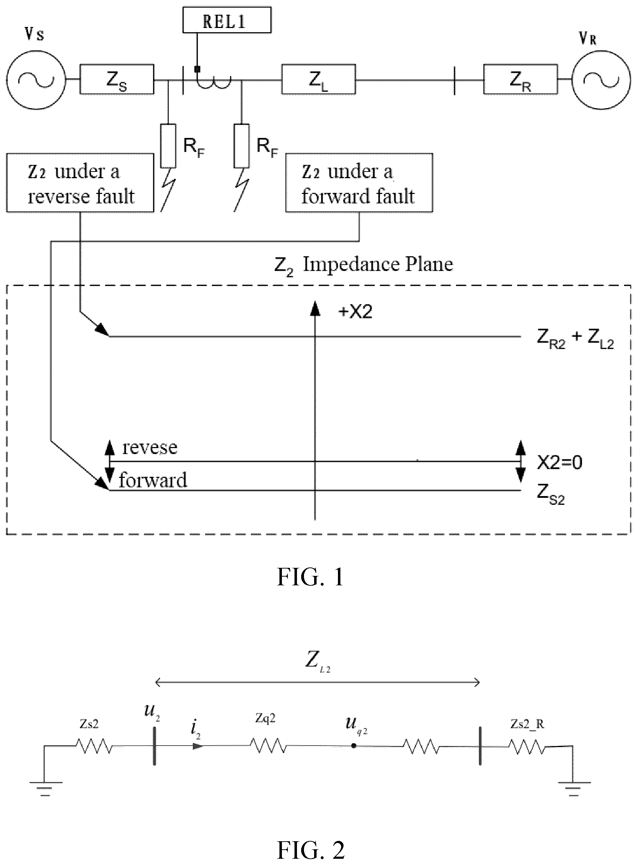

Fig.1 shows a simplified model diagram of a conventional dual power supply system. As shown in Fig. 1, power supplies $V_S$ and $V_R$, located at both ends of the circuit, are electrically connected to each other through an electrical power transmission line with an impedance $Z_L$. Assuming that during the normal operation of the system, the current flows from the power supply $V_S$ to $V_R$. $Z_S$ represents the system impedance at the side of the power supply $V_S$, $Z_R$ represents the system impedance at the side of the power supply $V_R$. In order to be able to cut off the transmission line between two power supplies in an emergency to protect the electric power system, a relay protection device REL1 is provided at the upstream endpoint of $Z_L$.

In the electric power system, when an asymmetric fault occurs, a negative-sequence current and negative-sequence voltage will be generated. The negative-sequence impedance-based directional element can determine which side of the system the fault occurred (i.e., determine the direction of the line fault relative to the relay protection device REL1) by analyzing the phase relationship (i.e., angle information) between the negative-sequence current and the negative-sequence voltage, thereby realizing the identification of the fault direction (i.e., a forward fault or a reverse fault). For the system model in Fig. 1, the negative-sequence impedance $Z_2$ at the relay protection device REL1 can be calculated according to the formula $Z_2 = \dot{U}_2/\dot{I}_2$ , where $\dot{U}_2$ and $\dot{I}_2$ are the negative-sequence voltage and the negative-sequence current at the relay protection device Respectively. This element determines the fault direction based on the phase angle between the negative-sequence voltage $\dot{U}_2$ and the negative-sequence current $\dot{I}_2$, $\theta_1 < \dot{U}_2/\dot{I}_2 < \theta_2$ , where $\theta_1, \theta_2$ are set phase angle thresholds. In the case of a forward fault, $Z_2 = \dot{U}_2/\dot{I}_2 = -Z_{S2}$ ; in the event of a reverse fault, $Z_2 = \dot{U}_2/\dot{I}_2 = Z_{L2} + Z_{R2}$ , where $Z_{S2}$ and $Z_{R2}$ represent the system impedances at both ends of the line. In Fig. 1, **"$X_2$"** refers to the imaginary part of the negative-sequence impedance $Z_2$ (i.e., $X_2 = imag(Z_2)$). Since the reactance in the line is usually much higher than its resistance, it is ideally assumed that the magnitude range of the negative-sequence impedance is mainly determined by the imaginary part.

In this context, the "forward fault" and a "reverse fault" of the system are defined based on the location of the line fault relative to the relay protection device. Here, "forward fault" is defined as a fault occurring downstream of the relay protection device, that is, from the perspective of the relay protection device, the fault point is located in front of the relay protection device along the current direction. A forward fault means that the fault occurs in the section of the line protected by the relay protection device. Conversely, "reverse fault" is defined as a fault occurring upstream of a relay protection device, i.e. the fault point is located behind the relay protection device from the perspective of the relay protection device. A reverse fault means that the fault occurs in the upstream portion of the line protected by the relay protection device.

However, this conventional negative-sequence impedance directional element has many drawbacks. For example, as can be appreciated from the above derivation formula for negative-sequence impedance, the negative-sequence impedance calculated by such a directional element is always positive under a reverse fault and always negative under a forward fault. therefore, it seems that a forward fault can be clearly distinguished from a reverse fault by the positive or negative sign of the negative-sequence impedance. However, for a super-strong system, since the negative-sequence voltage at the relay protection device is close to zero (since $Z_{S2} \approx 0$, $\dot{U}_2 \approx 0$) during a forward fault, considering the possible noise in the signal, the negative-sequence impedance at the relay protection device obtained eventually might be positive. That is, in this case, the fault direction cannot be determined from the sign of the negative-sequence impedance, which will lead to incorrect identification results by the directional element.

In addition, a negative-sequence impedance directional element based on amplitude information is also known in the prior art. For such a negative-sequence impedance directional element, in order to determine the fault direction, it is necessary to set a forward reference threshold $Z_{2F}$ and a reverse reference threshold $Z_{2R}$, which are related to impedances $Z_{S2}$ and $Z_{R2}$ of the upstream and downstream power supply systems, respectively. When $Z_2 < Z_{2F}$, it means a forward fault occurs; when $Z_2 > Z_{2R}$, it means a reverse fault occurs. However, such a directional element has many drawbacks, especially the need to set two reference thresholds $Z_{2F}$ and $Z_{2R}$. Particularly, for super-strong systems, the threshold for the forward fault must be carefully selected to ensure the reliability of the identification result, which brings unnecessary trouble to customers using the relay protection device product. In addition, these two thresholds are set based on system impedance, and the safety margin [$Z_{2F}$, $Z_{2R}$] between forward faults and reverse faults varies with different systems. When the system impedance changes during operation (such as generator connection/disconnection), the sensitivity or reliability of the directional element may decrease.

In view of the defects existing in the conventional directional elements, the present invention proposes a negative-sequence impedance directional element based on compensation voltage and a method for determining the fault direction. This directional element does not need to set reference thresholds based on the system impedances upstream and downstream of the protection relay protection device, and can achieve accurate determination of the fault direction even under a very small negative-sequence voltage.

FIG.2 shows a schematic diagram of an electric power system model using a negative-sequence impedance directional element based on compensation voltage. As shown in Fig.2, the line negative-sequence impedance of the electric power transmission line is $Z_{L2}$, and three-phase alternating current can be transmitted between two power systems through this transmission line, $Z_{S2}$ and $Z_{S2\_R}$ represent the system impedances at both ends of the line. Assuming the current flows from $Z_{S2}$ to $Z_{S2\_R}$, $u_2$ is the voltage value at the relay protection device provided in the electric power transmission line, and $i_2$ is the current value in the electric power transmission line. The negative-sequence impedance directional element based on compensation voltage is characterized in that a compensation point is selected between two endpoints of the electric power transmission line, and the negative-sequence impedance of the line between the compensation point and the relay protection device can be recorded as $Z_{q2}$.

Based on the system model in Fig.2, the negative-sequence compensation voltage $\dot{U}_{q2}$ at the compensation point can be derived as:

$$\dot{U}_{q2} = \dot{U}_2 - \dot{I}_2 Z_{q2} \qquad \text{——— (formula 1)}$$

In this formula, the negative-sequence voltage $\dot{U}_2$ and the negative-sequence current $I_2$ at the relay protection device can be derived from the three-phase current and three-phase voltage flowing through the transmission line, for example, using a symmetrical component method. The specific derivation process is not detailed here.

From the above formula (1), it can be seen that the negative-sequence compensation voltage $\dot{U}_{q2}$ at the compensation point has two characteristics: first, as long as the compensation point is within the transmission line protected by the relay protection device, $\dot{U}_{q2}$ will never be zero; in addition, even if the negative-sequence voltage $\dot{U}_2$ at the relay protection device is very small when a fault occurs (e.g., in a super-strong system), $\dot{U}_{q2}$ still has a large amplitude. Therefore, the directional element based on compensation voltage can work under conditions where the negative-sequence voltage is very small, for example, in a super-strong system, or under conditions with a very high ground fault impedance.

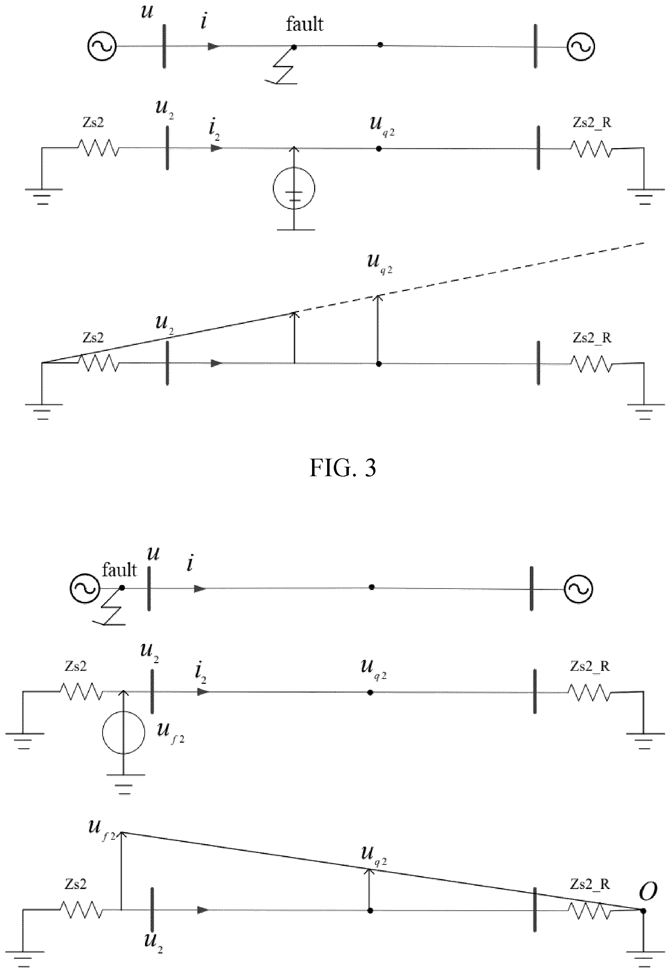

Fig.3 shows the performance of the directional element based on compensation voltage when a forward fault occurs. From Fig.3, it can be seen that when a forward fault occurs, $u_{q2} \gg u_2$. Even if $u_2$ is zero, $u_{q2}$ still has a larger amplitude, and when $u_2$ is zero,

$$\dot{U}_{q2} = \dot{U}_2 - \dot{I}_2 Z_{q2} = 0 - \dot{I}_2 Z_{q2} = -\dot{I}_2 Z_{q2}$$

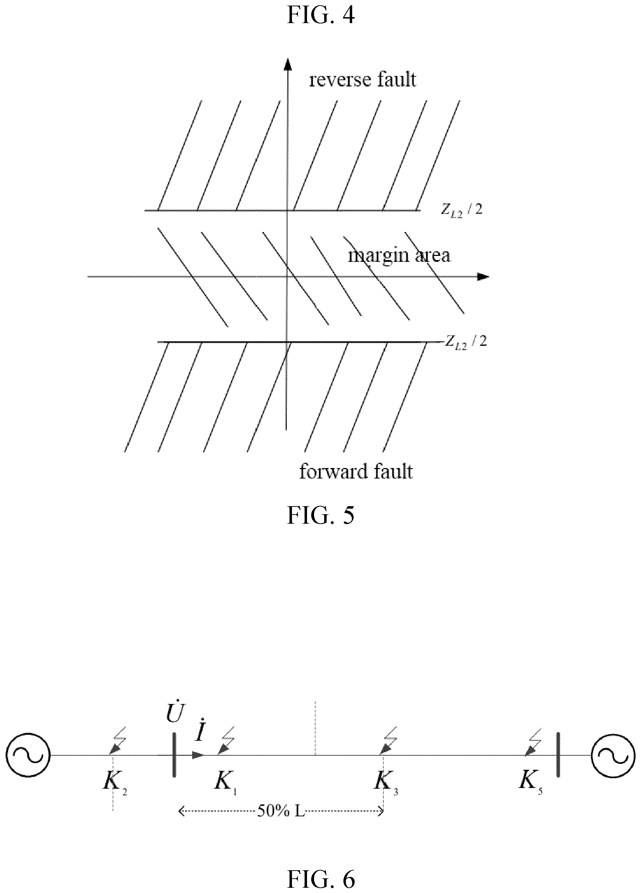

Fig.4 shows the performance of the directional element based on compensation voltage when a reverse fault occurs. From Fig.4, it can be seen that when a reverse fault occurs, $u_{q2}$ is not zero and maintains a relatively high value (only at node "O", the compensation voltage $u_{q2}$ is zero).

Returning to Fig.2, the negative-sequence impedance $Z_{c2}$ at the compensation point may be calculated as:

$$Z_{c2} = \frac{\dot{U}_{q2}}{\dot{I}_2} = \frac{\dot{U}_2 - \dot{I}_2 Z_{q2}}{\dot{I}_2} \qquad \text{——— (formula 2)}$$

Assuming that the compensation point is provided at the midpoint of the transmission line, the negative-sequence impedance of the entire transmission line is $Z_{L2}$, then the negative-sequence impedance at the compensation point is $Z_{q2} = Z_{L2}/2$. Combining formula 2, it can be deduced that the negative-sequence impedance $Z_{c2}$ at the

compensation point is:

$$Z_{c2} = \frac{\dot{U}_2 - \dot{I}_2 Z_{q2}}{\dot{I}_2} = \frac{\dot{U}_2 - \dot{I}_2 \times Z_{L2}/2}{\dot{I}_2} \qquad \text{—— (formula 3)}$$

When a forward fault occurs (as shown in Fig.3), it can be obtained:

$$Z_{c2} = \frac{\dot{U}_2 - \dot{I}_2 \times Z_{L2}/2}{\dot{I}_2} = \frac{\dot{U}_2}{\dot{I}_2} - \frac{\dot{U}_2 - \dot{I}_2 \times Z_{L2}/2}{\dot{I}_2} = -Z_{S2} - Z_{L2}/2 \qquad \text{——(formula 4)}$$

When a forward fault occurs, the angle of $Z_{c2}$ is **-90°** , and $Z_{c2}$ is always smaller than **$-Z_{L2}/2$**.

When a reverse fault occurs (as shown in Fig.4), it can be obtained:

$$Z_{c2} = \frac{\dot{U}_2 - \dot{I}_2 \times Z_{L2}/2}{\dot{I}_2} = \frac{\dot{U}_2}{\dot{I}_2} - \frac{\dot{I}_2 \times Z_{L2}/2}{\dot{I}_2} = Z_{L2} + Z_{SR2} - Z_{L2}/2 = Z_{L2}/2 + Z_{SR2} \qquad \text{—— (formula}$$

$$5)$$

When a reverse fault occurs, the angle of $Z_{c2}$ is **90°** , and $Z_{c2}$ is always larger than $Z_{L2}/2$.

From the above derivation process, it can be seen that when a forward fault occurs, $Z_{c2}$ **= -** $Z_{S2}$ **-** $Z_{L2}/2$, the negative-sequence impedance $Z_{c2}$ is always less than **$-Z_{L2}/2$** ; $Z_{c2}$ **=** $Z_{L2}/2$ **+** $Z_{SR2}$ , $Z_{c2}$ is always larger than $Z_{L2}/2$ when a reverse fault occurs.

Therefore, the thresholds of the directional element can be set as follows:

Forward fault:

$$Z_{c2} < -Z_{L2}/2 \qquad \text{—— (formula 6)}$$

Reverse fault:

$$Z_{c2} > Z_{L2}/2 \qquad \text{—— (formula 7)}$$

Fig.5 shows the performance of the negative-sequence impedance directional element based on compensation voltage. From Fig.5, it can be seen that the safety margin between forward fault and reverse fault is quite sufficient, thus even if the negative-sequence voltage sensed by the relay protection device is very small, the directional element is unlikely to make a misidentification.

In addition, in order to improve the reliability of the system, a reliability coefficient $k_1$ and $k_2$ can be added to the directional element for forward and reverse faults, respectively:

Forward fault:

$$Z_{c2} < k_1 \times (-Z_{L2}/2) \text{ ) } \qquad \text{——(formula 8)}$$

Reverse fault:

$$Z_{c2} > k_2 \times Z_{L2}/2 \text{ ) } \qquad \text{—— (formula 9)}$$

For example, $k_1$ and $k_2$ can be set to 0.8 or 0.9.

Considering that the angle of the negative-sequence impedance for the line is not 90 degree, the angle $Z_{c2}$ can be calculated using the following formula:

$$Z_{c2} = \frac{U_{q2}}{I_2} \times cos(\angle U_{q2} - \angle I_2 - RCA) \qquad \text{—— (formula 10)}$$

where $\dot{U}_{q2} = \dot{U}_2 - \dot{I}_2 Z_{q2} = \dot{U}_2 - \dot{I}_2 \times Z_{L2}/2$, RCA is the angle of the line negative-sequence impedance angle.

Furthermore, in addition to the above-described settings, the angle or amplitude information of $Z_{c2}$ can also be used to design directional element. Specifically, a directional element based on the angle information of $Z_{c2}$ can be defined as follows:

$$\theta_1 < arg \frac{\dot{U}_2 - \dot{I}_2 \times Z_{L2}/2}{\dot{I}_2 e^{j\delta}} < \theta_2 \qquad\text{——— (formula 11)}$$

where $\delta$ is the angle of the negative-sequence impedance for the line, i.e., $\delta = arg\, Z_{L2}$, $\theta_1$, $\theta_2$ are predetermined angle thresholds, which are set for $Z_{c2}$ to define different threshold ranges for forward and reverse faults, respectively.

For reverse faults, it can be set that $\theta_1 = -90°$, $\theta_2 = 90°$, thereby allowing for (assuming the angle $\delta$ in the following formula is 90°):

$$-90° < arg \frac{\dot{U}_2 - \dot{I}_2 \times Z_{L2}/2}{\dot{I}_2 e^{j\delta}} < 90° \qquad\text{———(formula 12)}$$

When the above condition is met, a reverse fault may be determined. For a forward fault $\theta_1 = 90°$, $\theta_2 = 270°$ may be set, so that:

$$90° < arg \frac{\dot{U}_2 - \dot{I}_2 \times Z_{L2}/2}{\dot{I}_2 e^{j\delta}} < 270° \qquad\text{———(formula 13)}$$

When the above condition is met, a forward fault may be determined.

Although this document focuses on the performance of the directional element according to the present invention under various fault conditions using "negative-sequence impedance" as an example, it is understood by those skilled in the art that a similar reasoning process can also be extended to zero-sequence or positive-sequence impedances. For instance, a zero-sequence impedance directional element based on compensation voltage can be designed to identify the direction of faults in the system. Such a directional element can also work under conditions where the zero-sequence voltage is very small, it is not only structurally simple but also highly reliable. Additionally, a positive-sequence directional element can be designed to identify the direction of faults in the system. All these variants fall within the protection scope of the present invention.

Fig.6 shows a model schematic of a fault occurring at different locations in a dual power supply system. Assume that the voltage level of this electric power system model is 245kV and the total length of the transmission line is 100 km. The positive-sequence system impedances of the two power supplies are $Z_S = 8.23e^{j89°}$ and $Z_R = 28.1e^{j89°}$. The positive-sequence impedance of the entire transmission line is 42.33 ohms with a sampling rate of 1 kHz. K1, K2, K3 and K5 are different fault points in the system, K1 is located at the starting end of the transmission line, K2 is located on the upstream side of the bus, K3 is located in the middle of the transmission line, and K5 is located at the end of the transmission line. K2 represents a reverse fault, and K1, K3, K5 represent a forward fault.

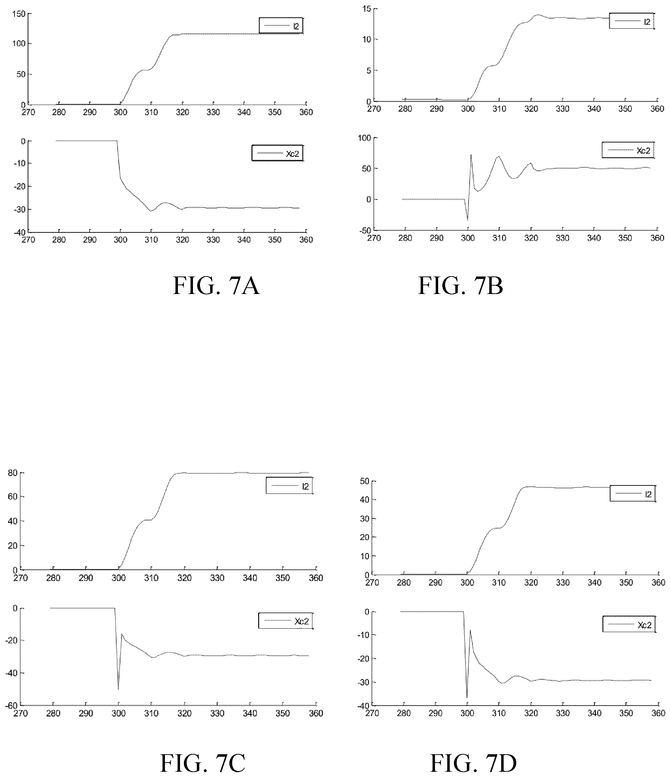

Fig.7A-7D show the simulation results of the negative-sequence impedance performance at the compensation point when a fault occurs at fault points K1, K2, K3, and K5, respectively. Before introducing the simulation results of Fig.7A-7D, it is worth noting that since the reactance in a line is typically much larger than its resistance, the simulation result at the compensation point is described herein by the imaginary part of the negative-sequence impedance $Z_{c2}$ (i.e., $X_{C2} = imag(Z_{C2})$).

Fig.7A, 7C, 7D show the simulation results at fault points K1, K3, K5 (i.e., forward faults). At these fault points, the imaginary part of the negative-sequence impedance $Z_{c2}$ obtained at the compensation point is-29.4 ohms **(imag($Z_S$ + $Z_L$/2) = 29.4)**, according to formula 6, it can be determined as a forward fault, where $Z_L$ is the line impedance.

Fig.7B shows the simulation results at fault point K2 (i.e., reverse fault). At this fault point, the imaginary part of the negative-sequence impedance $Z_{c2}$ obtained at the compensation point is 49.3 ohms **(imag($Z_R$ + $Z_L$/2) = 49.3),** and it can be determined as a reverse fault according to formula 7.

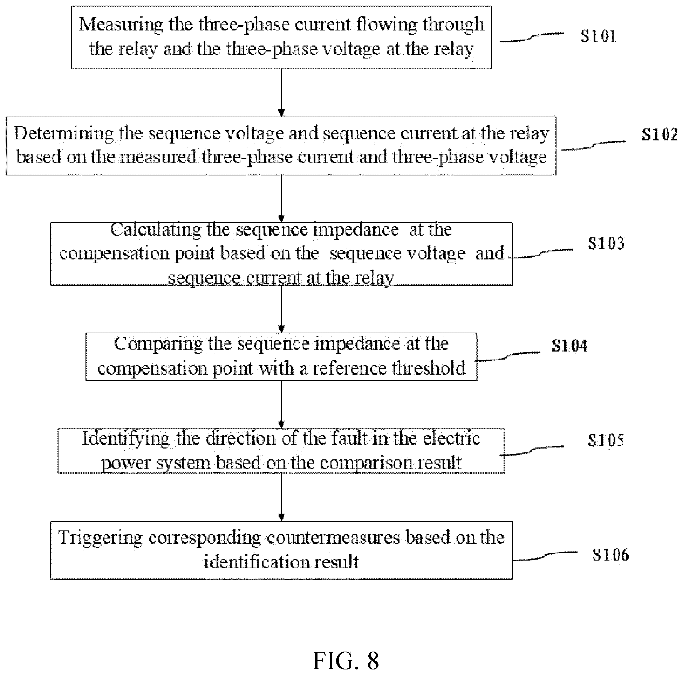

Fig.8 shows a flowchart of a method for identifying fault direction in an electrical power system according to an exemplary embodiment of the present invention. A simplified model of this electric power system is as shown in Fig.1, which may include two power supply networks $V_S$, $V_R$, and an electric power transmission line for transmitting three-phase alternating current between the two power supply networks.

At the first end of the electric power transmission line, which is located e.g. on the upstream side, a relay protection device REL1 may be provided, and this method may be implemented using the negative-sequence impedance directional element described above with reference to Fig.1-7D. It aims to determine the direction of a fault occurring in the electric power system relative to the relay protection device REL1. The following will detail the operation process of the fault direction identification method with reference to Fig. 8

First, in step S101, the three-phase current flowing through the relay protection device REL1 and the three-phase voltage at the relay protection device are measured. Subsequently, in step S102, the sequence voltage and sequence current at the relay protection device may be determined based on the measured three-phase current and the three-phase voltage. This process can be achieved, for example, by using conventional symmetrical component methods to decompose the three-phase voltage and current into three symmetrical components: i.e., a positive-sequence component, a negative-sequence component, and a zero-sequence component. This document focuses on the "negative-sequence components" (including the negative-sequence voltage $\dot{U}_2$, the negative-sequence current $\dot{I}_2$ and the negative-sequence impedance $Z_{c2}$) as an example to introduce the method for identifying the fault direction in the electric power system according to the present invention and the directional element implementing this method.

Based on the determined negative-sequence voltage $\dot{U}_2$ and negative-sequence current $\dot{I}_2$ at the relay protection device, in step S103, the negative-sequence impedance $Z_{c2}$ at a predetermined compensation point in the electric power transmission line can be further calculated. The compensation point can be set to be between the two endpoints of the electric power transmission line and it is assumed that the compensation impedance between this compensation point and the first endpoint located upstream is $Z_{q2}$. From the derivation formula 2 mentioned above, it is known that the calculation result of the negative-sequence impedance $Z_{c2}$ is associated with the compensation impedance $Z_{q2}$.

After determining the negative-sequence impedance $Z_{c2}$ at the compensation point, in step S104, the negative-sequence impedance $Z_{c2}$ can be compared with a reference threshold, and in step S 105, the comparison result can be used to determine the specific direction of the fault in the electric power system relative to the relay protection device. This embodiment is also characterized in that the fault direction in the electric power system can be determined based not only on the angle information of the sequence impedance at the compensation point but also on its amplitude information.

Assuming the current in the electric power system flows from the first endpoint to the second endpoint of the electric power transmission line, the reference threshold comprises a forward reference threshold and a reverse reference threshold larger than the forward reference threshold. Assuming the line negative-sequence impedance of the electric power transmission line is $Z_{L2}$, the reference threshold can be set based on the line negative-sequence impedance $Z_{L2}$ and the location of the compensation point in the electric power transmission line. For example, when the compensation point is located at the midpoint of the transmission line, the forward reference threshold can be set to $-Z_{L2}/2$, and the reverse reference threshold can be set to $Z_{L2}/2$. Specific derivation process can be referred to the formulas 6 and 7 mentioned above. In addition, a reliability coefficient $k_1$, $k_2$ may also be set for these two thresholds, see formulas 8, 9 mentioned above.

When the negative-sequence impedance $Z_{c2}$ at the compensation point is larger than the reverse reference threshold $Z_{L2}/2$, it indicates that a reverse fault has occurred in the electric power system; when the negative-sequence impedance $Z_{c2}$ at the compensation point is less than the forward reference threshold $-Z_{L2}/2$, it is determined that a forward fault has occurred in the electric power system.

Furthermore, the method may also include determining the sequence impedance angle $\theta$ at the predetermined compensation point based on the sequence voltage and sequence current at the first endpoint, and determining a fault direction in the electric power system based on this sequence impedance angle $\theta$. For example, when the negative-sequence impedance angle $\theta$ at the predetermined compensation point is within **-90°~90°**, it can be determined that a reverse fault has occurred in the electric power system; when the negative-sequence impedance angle $\theta$ at the predetermined compensation point is within **90°~ 270°,** it can be determined that a forward fault has occurred in the electric power system.

After determining the specific fault direction, in step S106, corresponding countermeasures can be triggered, such as opening the relay protection device to protect the circuit from being damaged.

An exemplary embodiment of the present invention also proposes a sequence impedance directional element based on compensation voltage, the sequence impedance directional element being arranged in an electric power system comprising two power supply networks and an electric power transmission line for transmitting three-phase alternating current between the two power supply networks. The particularity of this directional element lies especially in that it can be configured to use the method described with reference to Fig. 8 to identify the fault direction in the electric power system.

Another exemplary embodiment of the present invention also proposes a relay protection device for use in an electric power system. The relay protection device comprises: the aforementioned sequence impedance directional element; a control unit, being connected to the sequence impedance directional element and configured to output a corresponding control signal to a relay when the sequence impedance directional element identifies a forward fault or a reverse fault; and a relay connected to the control unit, the relay being configured to open the electric power transmission line upon receiving a control signal from the control unit.

Compared with traditional solutions, the negative-sequence impedance directional element based on compensation voltage and the fault direction identification method according to the present invention have the following advantages:

1) First, the directional element can identify the fault direction based on both the angle information and amplitude information of the negative-sequence impedance $Z_{c2}$ at the compensation point. Existing technologies can only use one of the amplitude information and the angle information to determine the fault direction. For example, some directional elements cannot use the sign of the negative-sequence impedance to determine the fault direction because when the negative-sequence voltage at the relay protection device is close to zero, the negative-sequence impedance is also close to zero. Due to the presence of noise, the determination based on the sign (angle) of the negative-sequence impedance becomes unreliable. However, in the method proposed by the present invention, when a line fault occurs, the negative-sequence compensation voltage will never be zero, therefore both the sign information and amplitude information of the angle of $Z_{c2}$ can be used to determine the fault direction;

2) The directional element based on $Z_{c2}$ amplitude does not require any settings. From the above formulas 6 and 7, it can be seen that the reference threshold of the directional element of the present invention is only related to the line impedance. The line impedance is an internal parameter of the system, it will not change with different systems, and customers do not need to set any threshold parameters for this directional element;

3) The directional element of the present invention has a greater degree of distinction for forward faults and reverse faults in terms of the negative-sequence impedance exhibited. For the directional element of the present invention, the negative-sequence reference threshold at the compensation point is always negative under forward faults and always positive under reverse faults. In contrast, for existing directional elements, the negative-sequence reference threshold is always positive under reverse faults, but under forward fault, the threshold could be either positive or negative. Therefore, the directional element of the present invention has a greater degree of distinction for forward faults and reverse faults;

4) Compared with the traditional directional element, the directional element provided by the invention has a larger safety margin between the forward fault area and the reverse fault area. The safety margin between the forward fault and the reverse fault of the proposed directional element is **[- $Z_{L2}$/2, $Z_{L2}$/2** ], whereas the safety margin of conventional directional elements is generally less than **[0, $Z_{L2}$/2 ]**;

5) The directional element of the present invention can directly determine the fault direction using the sign of $Z_{c2}$, which has a high reliability and thus a high response speed. For example, when $Z_{c2}$**>0,** it can be determined as a reverse fault directly, and when $Z_{c2}$**<0,** it can be determined as a forward fault. The reliability of the fault direction judgment can be further improved by means of the threshold values **-$Z_{L2}$/2** and **$Z_{L2}$/2** in the formulas 6 and 7;

6) Since the compensation voltage $U_{q2}$ will not be zero in any case (the compensation point is within the transmission line), the directional element has strong anti-noise capability; and

7) the ranges of the negative-sequence impedance at the compensation point are completely separated from each other for forward faults and reverse faults. For example, for forward faults, it is always located in the first and second quadrants, while for reverse faults, it is always located in the third and fourth quadrants.

It can be understood by those skilled in the art that the individual steps of the method according to the application are not limited to being carried out in the order listed above. In addition, in the present application, the terms "comprising" and "comprises" mean that, in addition to the steps directly or explicitly stated in the specification and claims, the technical solution of the present application also does not exclude other steps that have not been directly or explicitly stated.

Although the present invention has been disclosed in the form of preferred embodiments above, the invention is not limited to this. Any variations and modifications made by those skilled in the art within the spirit and scope of the invention should be included within the protection scope of the present invention. Therefore, the protection scope of the present invention should be determined by the claims.

**Claims**

**1.** Method for identifying a fault direction in an electric power system, the electric power system comprising two power supply networks and an electric power transmission line for transmitting three-phase alternating current between the two power supply networks, with a relay protection device being arranged at the first endpoint of the electric power transmission line, the method being intended to determine the direction of a fault occurring in the electric power system relative to the relay protection device, **characterized in that** the method comprises the steps of:

measuring the three-phase current flowing through the relay protection device and the three-phase voltage at the relay protection device;
determining the sequence voltage and the sequence current at the relay protection device based on the measured three-phase current and three-phase voltage;
calculating the sequence impedance at a predetermined compensation point in the electric power transmission line based on the determined sequence voltage and sequence current at the relay protection device, wherein the predetermined compensation point is located between the two endpoints of the electric power transmission line and the compensation impedance between the predetermined compensation point and the first endpoint is $Z_{q2}$, wherein the calculation result of the sequence impedance is associated with the compensation impedance $Z_{q2}$; and

comparing the calculated sequence impedance at the predetermined compensation point with a reference threshold, and determining the direction of a fault occurring in the electric power system relative to the relay protection device based on the comparison result.

2. The method according to claim 1, **characterized in that** it further comprises:

   determining the fault direction in the electric power system based on angle information and/or amplitude information of the sequence impedance at the predetermined compensation point.

3. The method according to claim 1 or 2, **characterized in that** the sequence voltage comprises the negative-sequence voltage $\dot{U}_2$ at the first endpoint, the sequence current comprises the negative-sequence current $\dot{I}_2$ at the first endpoint, and the sequence impedance comprises the negative-sequence impedance $Z_{c2}$ at the predetermined compensation point.

4. The method according to claim 3, **characterized in that** the current in the electric power system flows from the first endpoint to the second endpoint of the electric power transmission line, and the reference threshold comprises a forward reference threshold and a reverse reference threshold that is larger than the forward reference threshold, the method further comprising:

   determining that a reverse fault has occurred in the electric power system when the negative-sequence impedance at the predetermined compensation point is larger than the reverse reference threshold; and
   determining that a forward fault has occurred in the electric power system when the negative-sequence impedance at the predetermined compensation point is less than the forward reference threshold.

5. The method according to claim 4, **characterized in that** the line negative-sequence impedance of the electric power transmission line is $Z_{L2}$, wherein the reference threshold is set based on the line negative-sequence impedance $Z_{L2}$ and the location of the predetermined compensation point in the electric power transmission line.

6. The method according to claim 5, **characterized in that** assuming the predetermined compensation point is provided at the midpoint of the electric power transmission line, the forward reference threshold is set to $k_1 \times (-Z_{L2}/2)$ and the reverse reference threshold is set to $k_2 \times Z_{L2}/2$ , where $k_1$, $k_2$ are reliability coefficients.

7. The method according to any one of claims 4 to 6, **characterized in that** a sequence impedance angle ? at the predetermined compensation point is determined based on the sequence voltage and the sequence current at the first endpoint, and the fault direction in the electric power system is determined based on this sequence impedance angle ? .

8. The method according to claim 7, **characterized in that** it further comprises:

   determining that a reverse fault has occurred in the electric power system when the negative-sequence impedance angle ? at the predetermined compensation point is within a first reference range; and
   determining that a forward fault has occurred in the electric power system when the negative-sequence impedance angle ? at the predetermined compensation point is within a second reference range.

9. The method according to claim 8, **characterized in that** the first reference range is **-90?~90?** and the second reference range is **90?~270?**.

10. A sequence impedance directional element based on compensation voltage, which is arranged in an electric power system comprising two power supply networks and an electric power transmission line for transmitting three-phase alternating current between the two power supply networks, **characterized in that** the directional element is configured to identify a fault direction in the electric power system using the method according to any one of claims 1 to 9.

11. A relay protection device for use in an electric power system, **characterized by** comprising:

the sequence impedance directional element according to claim 10;
a control unit connected to the sequence impedance directional element and configured to output a corresponding control signal to a relay when the sequence impedance directional element identifies a forward fault or a reverse fault; and
a relay connected to the control unit, the relay being configured to disconnect the electric power transmission line upon receiving a control signal from the control unit.

FIG. 1

FIG. 2

FIG. 3

FIG. 4

FIG. 5

FIG. 6

FIG. 7A

FIG. 7B

FIG. 7C

FIG. 7D

Measuring the three-phase current flowing through the relay and the three-phase voltage at the relay —— S101

Determining the sequence voltage and sequence current at the relay based on the measured three-phase current and three-phase voltage —— S102

Calculating the sequence impedance at the compensation point based on the sequence voltage and sequence current at the relay —— S103

Comparing the sequence impedance at the compensation point with a reference threshold —— S104

Identifying the direction of the fault in the electric power system based on the comparison result —— S105

Triggering corresponding countermeasures based on the identification result —— S106

FIG. 8

Europäisches
Patentamt

European
Patent Office

Office européen
des brevets

# EUROPEAN SEARCH REPORT

**Application Number**

EP 24 20 6941

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 365 396 A (ROBERTS JEFFREY B [US] ET AL) 15 November 1994 (1994-11-15) * the whole document * | 1-11 | INV. H02H3/40 H02H3/38 G01R31/08 G01R31/52 |
| A | US 2019/293704 A1 (LIU KAI [CN]) 26 September 2019 (2019-09-26) * paragraphs [0018] - [0023], [0037] - [0038]; claim 1; figures 1, 2 * | 1-11 | ADD. H02H3/04 |

**TECHNICAL FIELDS SEARCHED (IPC)**

H02H
G01R

The present search report has been drawn up for all claims

| Place of search | Date of completion of the search | Examiner |
|---|---|---|
| Munich | 19 March 2025 | Trifonov, Antoniy |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 20 6941

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2025

| Patent document cited in search report | | Publication date | Patent family member(s) | | Publication date |
|---|---|---|---|---|---|
| US 5365396 | A | 15-11-1994 | CA | 2108443 A1 | 16-04-1994 |
| | | | US | 5349490 A | 20-09-1994 |
| | | | US | 5365396 A | 15-11-1994 |
| US 2019293704 | A1 | 26-09-2019 | CN | 109997287 A | 09-07-2019 |
| | | | EP | 3639337 A1 | 22-04-2020 |
| | | | US | 2019293704 A1 | 26-09-2019 |
| | | | WO | 2018227467 A1 | 20-12-2018 |

EPO FORM P0459

For more details about this annex : see Official Journal of the European Patent Office, No. 12/82